**Europäisches Patentamt**

**European Patent Office**

**Office européen des brevets**

(19)

(11) Veröffentlichungsnummer : **0 221 339**
**B1**

(12) **EUROPÄISCHE PATENTSCHRIFT**

(45) Veröffentlichungstag der Patentschrift :
01.02.89

(51) Int. Cl.⁴ : **H 01 J 49/38**, G 01 N 24/14

(21) Anmeldenummer : 86113410.4

(22) Anmeldetag : 30.09.86

(54) Ionen-Zyklotron-Resonanz-Spektrometer.

(30) Priorität : 29.10.85 DE 3538407

(43) Veröffentlichungstag der Anmeldung :
13.05.87 Patentblatt 87/20

(45) Bekanntmachung des Hinweises auf die Patenterteilung : 01.02.89 Patentblatt 89/05

(84) Benannte Vertragsstaaten :
CH DE FR GB LI

(56) Entgegenhaltungen :
DE--A-- 3 331 136
US--A-- 3 937 955
US--A-- 4 315 149
EUROPEAN SPECTROSCOPY NEWS, Nr. 58, März 1985, Chichester. R.L. SETTINE: "Fourier Transform Mass Spectrometry and its Combination with High Resolution Gas Chromatography"; Seiten 16-18

(73) Patentinhaber : **Spectrospin AG**
**Industriestrasse 26**
**CH-8117 Zürich-Fällanden (CH)**

(72) Erfinder : **Kellerhals, Hanspeter, Dr.**
**Hegetsbergstrasse 6**
**CH-8610 Uster (CH)**

(74) Vertreter : **Patentanwälte Kohler - Schwindling -**
**Späth**
**Hohentwielstrasse 41**
**D-7000 Stuttgart 1 (DE)**

EP 0 221 339 B1

## Beschreibung

Die Erfindung betrifft ein Ionen-Zyklotron-Resonanz-Spektrometer mit einer ein konstantes und in einem vorgegebenen Bereich homogenes Magnetfeld erzeugenden Magnetanordnung, mit zwei in dem Magnetfeld angeordneten Zellen, die Elektroden aufweisen, die bei Anliegen entsprechender Potentiale je eine Ionenfalle bilden, welche Zellen durch eine gemeinsame, zur Richtung des Magnetfeldes senkrechte und eine kleine Öffnung aufweisende Trennwand voneinander getrennt und mit Pumpeinrichtungen verbunden sind, die es gestatten, in den beiden Zellen unterschiedliche Vakua zu erzeugen, mit einer an die erste, auf ein geringeres Vakuum evakuierbaren Zelle angeschlossenen Ionisationseinrichtung und einer an die zweite, auf ein höheres Vakuum evakuierbaren Zelle angeschlossenen Sende- und Empfangseinrichtung und mit einem Netzgerät zum Anlegen von solchen Potentialen an die Elektroden, daß wahlweise die Ionen in der jeweiligen Ionenfalle gehalten oder zur Verteilung auf die beiden Zellen freigegeben werden.

Ein solches Ionen-Zyklotron-Resonanz-Spektrometer ist aus einem Aufsatz von R.L. Settine et al in « ESN-European-Spectroscopy News », 58, (1985), Seiten 16 bis 18, bekannt. Bei dem bekannten Spektrometer sind die beiden Zellen unmittelbar hintereinander im homogenen Bereich des Magnetfeldes angeordnet und weisen nicht nur in der Trennwand, sondern auch in den dazu parallelen Elektroden kleine Löcher oder Fenster auf, die es ermöglichen, durch die beiden Zellen einen Elektronenstrahl hindurchzuleiten. Dabei werden in der ersten Zelle, in der das geringere Vakuum herrscht, sehr viel mehr Ionen erzeugt als in der zweiten Zelle, in der das höhere Vakuum herrscht und daher die Gasdichte sehr viel geringer ist. So kann der Gasdruck in der ersten Zelle etwa $10^{-6}$ hPa und in der zweiten Zelle ca. $10^{-8}$ bis $10^{-9}$ hPa betragen. Daher wird in der ersten Zelle die Ionisation des Gases 100 bis 1 000 mal stärker sein als in der zweiten Zelle. Da sich beide Zellen im homogenen Bereich des Magnetfeldes befinden, bewegen sich die erzeugten Ionen aufgrund ihrer thermischen Energie zwar senkrecht zum Magnetfeld auf Zyklotron-Kreisbahnen, jedoch können sie sich in Richtung des Magnetfeldes frei bewegen und daher von der Zelle höheren Druckes in die Zelle niedrigeren Druckes übertreten. Auf diese Weise tritt eine gleichmäßige Verteilung der Ionen auf die beiden Zellen ein, so daß in der zweiten Zelle eine sehr viel größere Anzahl von Ionen zur Verfügung steht als allein durch eine Erregung des Gases in der zweiten erzeugt werden könnte.

Der Nachteil dieser bekannten Anordnung besteht darin, daß sich die beiden Zellen im homogenen Teil des Magnetfeldes befinden, wo es wegen des beschränkten Platzes und des Einflusses des Magnetfeldes nicht ohne weiteres möglich ist, unterschiedliche Methoden der Ionisierung anzuwenden. Bei der Anpassung von Ionisierungseinrichtungen an die engen Raumverhältnise im Magnetfeld muß auch dafür Sorge getragen werden, daß die Eigenschaften der zur Analyse benutzten Zelle nicht beeinträchtigt werden.

Es ist zwar beispielsweise aus der zum Stand der Technik gehörenden DE-A-35 15 766.6 bekannt, Ionen außerhalb des Magnetfeldes zu erzeugen und dann in die sich im Magnetfeld befindenden Analysatorzelle in Form eines Ionenstrahles zu übertragen. Dabei kann die Erzeugung der Ionen unter Verwendung aller bekannten Methoden bei einem normalen Hochvakuum im Bereich von $10^{-5}$ hPa stattfinden, während die Meßzelle wiederum durch differentielles Pumpen auf einen geringeren Druck von etwa $10^{-8}$ hPa gehalten werden kann. Trotzdem ist auch dieses bekannte Verfahren noch problematisch, da die Wirksamkeit der Ionenübertragung relativ gering ist. Weiterhin ist die für die Übertragung der Ionen erforderliche Apparatur relativ kompliziert und muß mit äußerster Genauigkeit justiert werden, um das Einführen der Ionen in die Meßzelle zu gewährleisten. Ein weiterer Nachteil besteht darin, daß keine Möglichkeit besteht, während des eigentlichen Meßvorganges erzeugte Ionen zu speichern.

Noch komplizierter gestaltet sich die Übertragung extern erzeugter Ionen in die Meßzelle unter Verwendung von Quadrupol-Elementen, wie es von R. T. McIver et al in « Proc. 31. Annu. Conf. Mass Spectrom. Allied Top, 1983, Boston » beschrieben worden ist. Zudem ist auch hierbei eine geringe Übertragungs-Wirksamkeit zu erwarten.

Demgegenüber liegt der Erfindung die Aufgabe zugrunde, ein Ionen-Zyklotron-Resonanz-Spektrometer der eingangs genannten Art so zu verbessern, daß die Erzeugung der Ionen mit einfachen Vorrichtungen nach jeder beliebigen Methode erfolgen kann.

Diese Aufgabe wird nach der Erfindung dadurch gelöst, daß die erste Zelle einen außerhalb der Magnetanordnung im Bereich von dessen Streufeld liegenden Abschnitt aufweist und die Ionisationseinrichtung an diesen Abschnitt der ersten Zelle angeschlossen ist.

Bei dem erfindungsgemäßen Spektrometer ist demnach die unter dem höheren Druck stehende Zelle, an welche die Ionisationeinrichtung angeschlossen ist, so groß ausgebildet, daß sie sich bis in einen außerhalb der Magnetanordnung liegenden Bereich erstreckt, wo sie für beliebige Ionisationseinrichtungen zugänglich ist. Diese Ionisationseinrichtungen können demnach ohne wesentliche Platzbeschränkung und ohne Rücksicht auf das zur Messung erforderliche, homogene Magnetfeld aufgebaut werden, das durch die außerhalb der Magnetanordnung liegenden Teile nicht mehr nennenswert beeinflußt wird. Daher ist bei dem erfindungsgemäßen Spektrometer eine höchst effektive Ionisierung des in der ersten Zelle enthaltenen Gases möglich. Die Ausbildung der Zellen gestattet es dann, wie bei dem bekannten Spektrometer, beide Zellen als Einheit zu betreiben, so daß sich die Ionen auf beide Zellen gleichmäßig verteilen. Entsprechend dem Größenverhältnis der beiden Zellen tritt dabei nur ein kleiner Anteil der erzeugten Ionen in die kleinere Meßzelle ein, jedoch kann auch während der Ionisierungsphase infolge des größeren Anteiles von unter höherem Druck stehendem Gas eine größere Ionenzahl erzeugt werden, so daß insofern kein wesentlicher Verlust gegenüber der in der Meßkammer erzielbaren Ionendichte des bekannten Spektrometers eintritt.

Während der Ionisationsphase wird die gesamte Zellenanordnung als Ionenfalle betrieben, weshalb auch der außerhalb der Magnetanordnung liegende Anteil der ersten Zelle noch einem Magnetfeld ausgesetzt sein muß, das zusammen mit den an der Zelle anliegenden Potentialen das Gefangenhalten der Ionen in den Zellen gewährleistet. Für den Fall, daß das Streufeld hierzu nicht ausreicht, kann der außerhalb der Magnetanordnung liegende Abschnitt der ersten Zelle im Bereich des Feldes eines Zusatzmagneten angeordnet sein. Ein solcher Zusatzmagnet, der kein Feld besonders hoher Stärke und besonders guter Homogenität zu erzeugen braucht, läßt sich mit geringem Aufwand herstellen und so anordnen, daß er die Ionisation nicht stört.

In weiterer Ausgestaltung der Erfindung können in der ersten Zelle eine Anzahl zur Zwischenwand parallele Gitter angeordnet und mit dem Netzgerät elektrisch leitend verbunden sein, das eine Einrichtung zum Steuern der an die Gitter angelegten Potentiale in solcher Weise umfaßt, daß die Ionenfalle von durch die Gitter begrenzten Abschnitten der ersten Zelle gebildet wird und längs der ersten Zelle von dem außerhalb der Magnetanordnung liegenden Bereich bis zur Trennwand und gegebenenfalls noch über diese hinaus verschiebbar ist. Auf diese Weise ist es möglich, die erzeugten Ionen längs der ersten Zelle zu verschieben und praktisch vollständig in die zweite Zelle zu übertragen, so daß eine außerordentlich hohe Wirksamkeit der Übertragung gewährleistet ist. Es läßt sich daher bei dieser Variante des erfindungsgemäßen Spektrometers unter den Bedingungen eines Ultra-Hochvakuums eine Ionendichte erzielen, wie sie bisher für nicht möglich gehalten wurde. Dadurch lassen sich Empfindlichkeit und Auflösungsvermögen eines solchen Spektrometers bedeutend steigern.

In weiterer Ausgestaltung der Erfindung kann auch in der zweiten Zelle eine Anzahl zur Zwischenwand paralleler Gitter angeordnet und mit dem Netzgerät elektrisch leitend verbunden sein, welche die Ionenfalle auf einem der Trennwand benachbarten Abschnitt der zweiten Zelle begrenzen. In diesem Fall würde die Zelle im wesentlichen nur ein Vakuum-Gefäß darstellen, in dem sich die die Meßkammer bildende Ionenfalle befindet, die im Hinblick auf die Ionen-Zyklotron-Resonanz-Messungen optimal gestaltet ist. Dabei besteht dann die Möglichkeit, zwischen der Trennwand und dem die Ionenfalle der zweiten Zelle begrenzenden, der Trennwand benachbarten Gitter eine Schirmelektrode anzuordnen. Eine solche Schirmelektrode ermöglicht es, durch Anlegen eines ausreichend hohen Potentials eine elektrische Trennung zwischen den beiden Zellen herzustellen, so daß ohne weiteres in der ersten Zelle die Ionisierung des darin enthaltenen Gases stattfinden kann, während in der zweiten Zelle die Ionen-Zyklotron-Resonanz-Messung durchgeführt wird. Dabei kann die Schirmelektrode auch so ausgebildet und mit einem solchen Potential beaufschlagt sein, daß zur Ionisation verwendete Elektronen- oder Ionenstrahlen nicht bis zur Meßkammer vordringen können.

Bei einer bevorzugten Ausführungsform der Erfindung können innerhalb der ersten und/oder zweiten Zelle wenigstens zwischen zwei benachbarten Gittern zum Magnetfeld parallele Elektroden zum Erzeugen von zur Erzeugung von Ionen-Zyklotron-Resonanzen geeigneten Wechselfeldern angeordnet sein. Auf diese Weise läßt sich auch in der ersten Zelle eine Zone herstellen, die sich in dem homogenen Bereich des von der Magnetanordnung erzeugten Magnetfeldes befindet und in der daher Ionen-Zyklotron-Resonanzen für vorgegebene Massen/Ladungs-Verhältnisse erzeugbar sind. Diese Anordnung ermöglicht die Selektion bestimmter Ionen, die dann in der eingangs behandelten Weise in die Meßzelle übertragen werden können.

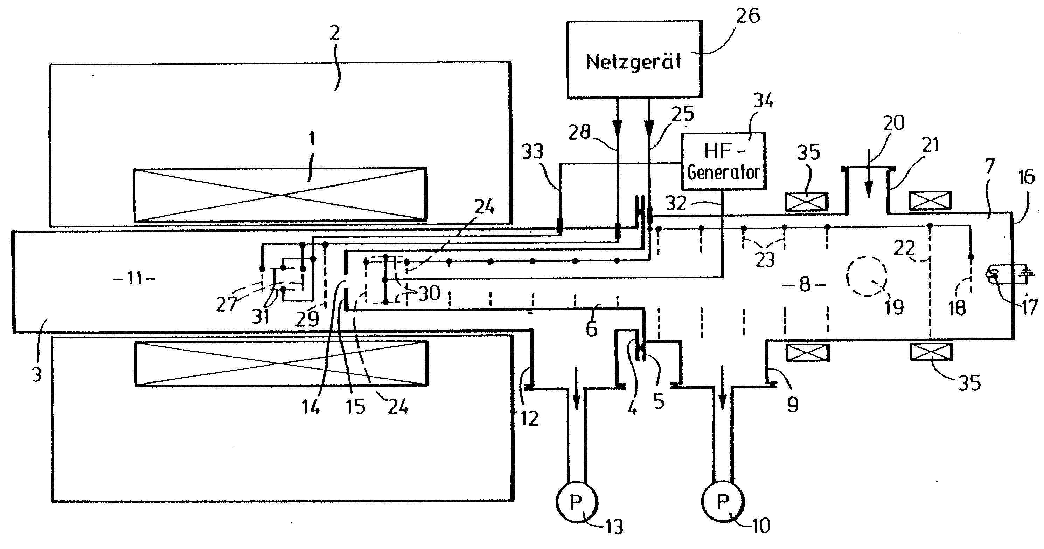

Die Erfindung wird im folgenden anhand eines in der Zeichnung rein schematisch dargestellten Spektrometers näher beschrieben und erläutert. Die der Beschreibung und der Zeichnung zu entnehmenden Merkmale können bei anderen Ausführungsformen der Erfindung einzeln für sich oder zu mehreren in beliebiger Kombination Anwendung finden.

Das in der Zeichnung dargestellte Ionen-Zyklotron-Resonanz-Spektrometer weist eine Magnetanordnung auf, die aus einer supraleitenden Spule 1 und einem die Spule umschließenden Dewar 2 besteht. Der von der Spule 1 und dem Dewar 2 umschlossene, zylindrische Hohlraum wird von einem Rohr 3 durchsetzt, das an einem Ende geschlossen ist und am anderen Ende einen Flansch 4 aufweist, mit dem der Flansch 5 eines weiteren Rohres 6 dicht verbunden ist, das konzentrisch in das Rohr 3 hineinragt und bis nahe zur Längsmitte der Spule 1 reicht. Nach außen schließt sich an den Flansch 5 ein weiteres Rohr 7 an, dessen Durchmesser größer ist als die Durchmesser der anderen Rohre 6 und 3. Die Rohre 6 und 7 bilden eine erste Zelle 8, die außerhalb der Magnetanordnung im Bereich des Rohres 7 mit einem seitlichen Stutzen 9 versehen ist, an den eine Vakuumpumpe 10 angeschlossen ist. Die Vakuumpumpe 10 ist dazu eingerichtet, ein normales Hochvakuum mit einem Druck von etwa $10^{-5}$ hPa zu erzeugen. Ähnlich bildet auch das Rohr 3 mit seinem Flansch 4 eine zweite Zelle 11, die an einer außerhalb des Dewar 2 liegenden Stelle mit einem Stutzen 12 versehen ist, an den eine Pumpe 13 angeschlossen ist. Diese Pumpe 13 ist zur Erzeugung eines Ultra-Hochvakuums mit einem Druck von etwa $10^{-8}$ hPa eingerichtet.

Die beiden Zellen 8 und 11 stehen durch eine kleine Öffnung 14 miteinander in Verbindung, die in der das Rohr 6 der ersten Zelle 8 abschließenden Trennwand 15 angeordnet ist.

An dem von der Trennwand 15 abgewandten Ende der ersten Zelle 8 befindet sich nahe dem Boden 16 des Rohres 7 ein Glühfaden 17, der bei entsprechender Beheizung Elektronen emittiert. Diese Elektronen können mittels eines Beschleunigungsgitters 18 auf einen benachbarten Ionisationsbereich 19 gerichtet werden, wo sie auf die in der ersten Zelle 8 enthaltenen Gasmoleküle treffen. Das zu untersuchende Gas kann der ersten Zelle 8 über ein nur schematisch durch den Pfeil 20 und den Stutzen 21 angedeutetes Einlaßsystem zugeführt werden.

In der ersten Zelle befindet sich eine Anzahl axial hintereinander angeordneter Potentialgitter 22, 23, 24, die über ein Kabel 25, das eine entsprechende Anzahl Leitungen umfaßt, mit einem Netzgerät 26 verbunden sind. Das Netzgerät 26 erlaubt es, an die Potentialgitter unterschiedliche Potentiale anzulegen.

Ähnlich befinden sich auch in der zweiten Zelle 11 in relativ geringem Abstand von der Trennwand 15 der ersten Zelle 8 zwei Potentialgitter 27, die ebenfalls über ein entsprechendes Kabel 28 mit dem Netzgerät 26 elektrisch leitend verbunden sind. Zwischen dem einen der Potentialgitter 27 und der Trennwand 15 der ersten Zelle 8 befindet sich außerdem eine Schirmelektrode 29, die ebenfalls über eine Leitung des Kabels 28 mit dem Netzgerät 26 verbunden ist. Im Bereich zwischen den Elektroden 24, die der Trennwand 15 der ersten Zelle 8 benachbart sind, und den beiden Elektroden 27 in der zweiten Zelle 11 befinden sich jeweils zur Rohrachse parallele Elektroden 30 bzw. 31, die jeweils über ein Kabel 32 bzw. 33 mit je einem Ausgang eines HF-Generators 34 verbunden sind. Die Potentialgitter 27 mit den zugehörigen Elektroden 31 bilden die Ionen-Zyklotron-Resonanz-Meßzelle. Diese ist im Zentrum des Magneten angeordnet, wo das Feld der Magnetspule 1 äusserst homogen ist. Der durch die Elektroden 30 erfaßte Abschnitt der Zelle 8 befindet sich noch im Inneren der Spule 1 und damit in einem Bereich des Magnetfeldes mit guter Homogenität, was durch Einstrahlung geeigneter Zyklotronfrequenzen über die genannten Elektroden eine selektive Eliminierung unerwünschter Ionen gestattet. Ein großer Teil der ersten Zelle 8 befindet sich nur noch im Streufeld der Magnetanordnung, weshalb zu beiden Seiten des in der ersten Zelle 8 vorgesehenen Ionisationsbereiches 19 zwei das Rohr 7 umgebende, weitere Magnetspulen 35 angeordnet sind. Das von diesen beiden Magnetspulen 35 erzeugte Feld hat eine nur mäßige Stärke und auch nur mäßige Homogenität im Ionisationsbereich, die jedoch ausreichend ist, um erzeugte Ionen auf Zyklotron-Bahnen zu zwingen und dadurch in einem bestimmten Bereich der ersten Zelle 8 zu halten.

Im Betrieb wird eine mittels der Einrichtung 20 in den Ionisationsbereich 19 eingeführte Substanz durch Beschießen mit den von dem Glühfaden 17 erzeugten und durch das Potentialgitter 18 beschleunigten Elektronen ionisiert. Dieser Vorgang findet bei dem von der Pumpe 10 erzeugten, normalen Hochvakuum im Bereich von etwa $10^{-5}$ hPa statt. Durch Anlegen geeigneter Potentiale an die Potentialgitter 22, 23 können die erzeugten Ionen ähnlich wie in einer Ionenfalle im Ionisationsbereich gehalten werden. Durch Ändern der an den Potentialgittern 23 anliegenden Potentiale durch entsprechendes, gegebenenfalls programmiertes Einstellen des Netzgerätes 26 ist es möglich, die von jeweils zwei Potentialgittern 22, 23 begrenzte Ionenfalle, die ohne weiteres einen sich über mehrere hintereinander angeordnete Potentialgitter erstreckenden Bereich umfassen kann, in Richtung auf das im Bereich der Magnetspule 1 gelegene Ende der ersten Zelle 8 zu verschieben. Dabei wäre auch denkbar, daß zunächst die gesamte erste Zelle 8 eine Ionenfalle bildet, so daß infolge der Bewegung der Gasmoleküle und Ionen das gesamte in der ersten Zelle 8 enthaltene Gas zu einem wesentlichen Teil ionisiert wird, worauf dann durch Verändern der Potentiale das zunächst von dem dem Boden 16 der ersten Kammer 8 benachbarten Potentialgitter 22 gebildete Ende der Ionenfalle immer mehr in Richtung auf das sich innerhalb der Magnetspule 1 befindende Ende dieser Zelle verschoben wird, bis sich schließlich alle Ionen nahe diesem Ende befinden. Befinden sich alle Ionen zwischen den der Trennwand 15 benachbarten Potentialgittern 24, erlauben es die Elektroden 30 durch Anlegen einer vom HF-Generator 34 gelieferten Spannung ein Selektieren der Ionen. Die ausgewählten Ionen werden dann durch entsprechendes Ändern der Potentiale an den Potentialgittern 24 und 27 auf den von den Potentialgittern 27 in der zweiten Zelle 11 begrenzten Raum übertragen, der eine zweite Ionenfalle bildet. Innerhalb dieser Ionenfalle können dann die Ionen mittels der Elektroden 31 zur Resonanz angeregt werden. Nicht näher dargestellte Elektroden können dann zum Empfang der Resonanz-Signale benutzt werden.

Es ist ersichtlich, daß bei dem dargestellten Spektrometer in dem Bereich 19 beliebige Substanzen auf beliebige Weise ionisiert werden können, weil der Ionisationsbereich außerhalb der Magnetanordnung 1, 2 liegt und daher für alle Maßnahmen frei zugänglich ist. Die erzeugten Ionen lassen sich dann durch Verschieben der Grenzen einer Ionenfalle, die von Potentialgittern 22, 23, 24, 27 gebildet wird, von der Zelle 8 in die Zelle 11 transportieren, wo dann eine genaue Bestimmung der Ionenzyklotron-Resonanzen stattfindet. Dabei befinden sich die Ionen in dem Abschnitt der Magnetanordnung 1, 2 größter Homogenität sowie in großer Anzahl in einem Ultra-Hochvakuum, so daß gleichzeitig größte Empfindlichkeit und größte Auflösung erzielbar ist. Dabei gestattet es die Schirmelektrode 29 durch Anlegen eines geeigneten Potentials die von den Potentialgittern 27 begrenzte Ionenfalle in der zweiten Zelle 11 gegenüber Einwirkungen abzuschirmen, die noch von der der Ionisation dienenden ersten Zelle 8 ausgehen könnten. Daher besteht bei dem dargestellten Spektrometer die Möglichkeit, während des Meßvorganges in der zweiten Zelle 11 in der ersten Zelle 8 eine neue Probenmenge zu ionisieren, die erzeugten Ionen zu speichern und gegebenenfalls auch noch in der sich innerhalb der Magnetspule 1 befindenden Zone 24, 30 zu selektieren. Damit ermöglicht das dargestellte Spektrometer eine Verkürzung der sonst benötigten Meßzeiten.

Es versteht sich, daß die Erfindung nicht auf das dargestellte Ausführungsbeispiel beschränkt ist, sondern Abweichungen davon möglich sind, ohne den Rahmen der Erfindung wie in den Ansprüchen definiert zu verlassen. So können anstelle einer Elektronenkanone auch andere Einrichtungen zur Ionisierung einer Probensubstanz verwendet werden, so daß auch Probensubstanzen beliebiger Art ionisiert werden können. Weiterhin kann der Aufbau der Zellen und der darin angeordneten Potentialgitter und Elektroden von dem dargestellten Ausführungsbeispiel abweichen, was insbesondere dann der Fall sein wird, wenn anstelle eines Kryomagneten ein Eisenmagnet mit seiner völlig anderen Konfiguration Anwendung findet.

**Patentansprüche**

1. Ionen-Zyklotron-Resonanz-Spektrometer mit einer Magnetanordnung (1, 2), die in einem von ihr begrenzten Bereich ein konstantes und homogenes Magnetfeld erzeugt, mit zwei in dem Magnetfeld angeordneten Zellen (8, 11), die Elektroden (18, 22, 23, 24, 27, 29) aufweisen, die bei Anliegen entsprechender Potentiale je eine Ionenfalle bilden, welche Zellen durch eine gemeinsame, zur Richtung des Magnetfeldes senkrechte und eine kleine Öffnung (14) aufweisende Trennwand (15) voneinander getrennt und mit Pumpeinrichtungen (10, 13) verbunden sind, die es gestatten, in den beiden Zellen (8, 11) unterschiedliche Vakua zu erzeugen, mit einer an die erste, auf ein geringeres Vakuum evakuierten Zelle (8) angeschlossenen Ionisationseinrichtung (17, 18) und einer an die zweite, auf ein höheres Vakuum evakuierbaren Zelle (11) angeschlossenen Sende- und Empfangseinrichtung und mit einem Netzgerät (26) zum Anlegen von solchen Potentialen an die Elektroden, daß die Ionen wahlweise in der jeweiligen Ionenfalle gehalten oder zur Verteilung auf die beiden Zeilen freigegeben werden, dadurch gekennzeichnet, daß die erste Zelle (8) einen Abschnitt (19) aufweist, der aus dem von der Magnetanordnung (1, 2) begrenzten Bereich herausragt und im Streufeld der Magnetanordnung liegt, so daß er von der Magnetanordnung unbehindert zugänglich ist, und daß die Ionisationseinrichtung (17, 18) an diesen Abschnitt der ersten Zelle (8) angeschlossen ist.

2. Spektrometer nach Anspruch 1, dadurch gekennzeichnet, daß der außerhalb des von der Magnetanordnung (1, 2) begrenzten Bereichs liegende Abschnitt der ersten Zelle (8) im Bereich des Feldes eines Zusatzmagneten (35) angeodnet ist.

3. Spektrometer nach Anspruch 1 oder 2, dadurch gekennzeichnet daß in der ersten Zelle (8) eine Anzahl zur Trennwand (15) paralleler Potentialgitter (22, 23, 24) angeordnet und mit dem Netzgerät (26) elektrisch leitend verbunden ist, das eine Einrichtung zum Steuern der an die Potentialgitter angelegten Potentiale in solcher Weise umfaßt, daß die Ionenfalle von durch Potentialgittern (22, 23, 24) begrenzten Abschnitten der ersten Zelle (8) gebildet wird und längs der ersten Zelle von dem außerhalb der Magnetanordnung (1, 2) liegenden Bereich bis zur Trennwand (15) und gegebenenfalls noch über diese hinaus verschiebbar ist.

4. Spektrometer nach einem der vorhergehenden Ansprüche, dadurch gekennzeichnet, daß in der zweiten Zelle (11) eine Anzahl zur Trennwand (15) paralleler Potentialgitter (27) angeordnet und mit dem Netzgerät (26) elektrisch leitend verbunden ist, welche die Ionenfalle auf einen der Trennwand (15) benachbarten Abschnitt der zweiten Zelle (11) begrenzen.

5. Spektrometer nach Anspruch 4, dadurch gekennzeichnet, daß zwischen der Trennwand (15) und dem die Ionenfalle der zweiten Zelle (11) begrenzenden, der Trennwand (15) benachbarten Potentialgitter (27) eine Schirmelektrode (19) angeordnet ist.

6. Spektrometer nach einem der Ansprüche 3 bis 5, dadurch gekennzeichnet, daß innerhalb der Zelle (8) wenigstens zwischen zwei benachbarten Potentialgittern (24) zum Magnetfeld parallele Elektroden (30) zum Erzeugen von zum Erregen von Ionen-Zyklotron-Resonanzen geeigneter Wechselfelder angeordnet sind.

**Claims**

1. Ion cyclotron resonance spectrometer with a magnet arrangement (1, 2) which generates, in a region bounded by it, a constant and homogeneous magnetic field with two cells (8, 11) arranged in the magnetic field which have electrodes (18, 22, 23, 24, 27, 29) which, on being subjected to corresponding potentials, each form an iontrap, which cells are separated from one another by a common separating wall (15) perpendicular to the direction of the magnetic field and having a small opening (14) and are connected with pumping devices (10, 13) which allow differing vacua to be generated in both of the cells (8, 11), with an ionisation device (17, 18) connected to the first cell (8) evacuated to a low vacuum and a sending and receiving device connected to the second cell (11) evacuatable to a higher vacuum, and with a power supply device (26) for applying such potentials to the electrodes that the ions are held selectively in the respective iontraps or are freed for distribution over both of the cells, characterized in that the first cell (8) has a section (19) which projects from the region bordered by the magnet arrangement (1, 2) and lies in the stray field of the magnet arrangement so that it is accessible unhindered by the magnet arrangement and that the ionisation device (17, 18) is connected to this section of the first cell (8).

2. Spectrometer according to Claim 1, characterized in that the section of the first cell (8) lying outside the region limited by the magnet arrangement (1, 2) is arranged in the region of the field of an additional magnet (35).

3. Spectrometer according to Claim 1 or 2, characterized in that in the first cell (8) there are arranged a number of potential grids (22, 23, 24) parallel to the separating wall (15) and are connected in electrically conducting fashion with the power supply device (26), which includes a device for controlling the potentials applied to the potential grids in such fashion that the ion traps are constituted by sections of the first cell (8) bounded by potential grids (22, 23, 24) and is displaceable along the first cell from the region lying outside the magnet arrangement (1, 2) up to the separating wall (15) and optionally yet further past this.

4. Spectrometer according to one of the preceding claims, characterized in that in the second cell (11) a number of potential grids (27) are arranged parallel to the separating wall (15) and electrically connected with the power supply device (26) which limits the ion trap to a section of the second cell (11) adjacent the separating wall (15).

5. Spectrometer according to Claim 4, characterized in that a screen electrode (19) is arranged between the separating wall (15) and the potential grid (27) adjacent the separating wall (15) limiting the ion trap of the second cell (11).

6. Spectrometer according to one of Claims 3 to 5, characterized in that within the cell (8), at least between two neighbouring potential grids (24), electrodes (30) parallel to the magnetic field are arranged for generating alternating fields suitable for stimulating ion cyclotron resonance.

**Revendications**

1. Spectromètre à résonance cyclotronique et ionique comportant un dispositif d'aimants (1, 2), qui produit, dans une zone délimitée par ce dispositif, un champ magnétique constant et homogène, deux cellules (8, 11) disposées dans le champ magnétique et comportant des électrodes (18, 22, 23, 24, 27, 29) qui, lors de l'application de potentiels correspondants, forment des puits respectifs pour les ions, ces cellules étant séparées l'une de l'autre par une paroi commune de séparation (15) perpendiculaire à la direction du champ magnétique et possédant une petite ouverture (14), et étant reliées par des dispositifs de pompage (10, 13) permettant de produire des vides différents dans les deux cellules (8, 11), un dispositif d'ionisation (17, 18) raccordé à la première cellule (8), dans laquelle un vide plus faible est établi, et un dispositif d'émission et de réception raccordé à la seconde cellule (11), dans laquelle un vide plus important est établi, et un appareil d'alimentation réseau (26) servant à appliquer aux électrodes des potentiels tels que les ions sont, au choix, maintenus dans les puits respectifs pour les ions ou bien libérés de manière à être répartis entre les deux cellules, caractérisé par le fait que la première cellule (8) possède une section (19) qui ressort hors de la zone délimitée par le dispositif d'aimants (1, 2) et est située dans le champ de fuite du dispositif d'aimants de sorte que cette section est accessible librement sans aucune gêne pour le dispositif d'aimants, et que le dispositif d'ionisation (17, 18) est raccordé à cette section de la première cellule (8).

2. Spectromètre suivant la revendication 1, caractérisé par le fait que la section de la première cellule (8), qui est à l'extérieur de la zone délimitée par le dispositif d'aimants (1, 2), est située dans la zone du champ d'un aimant supplémentaire (35).

3. Spectromètre suivant la revendication 1 ou 2, caractérisé par le fait qu'un certain nombre de grilles de potentiel (22, 23, 24) parallèles à la paroi de séparation (15) sont disposées dans la première cellule (8) et reliées d'une manière électriquement conductrice à l'appareil d'alimentation réseau (26), qui comprend un dispositif servant à commander les potentiels appliqués aux grilles de potentiel de telle sorte que le puits pour les ions est formé par des sections de la première cellule (8) délimitées par des grilles de potentiel (22, 23, 24) et peut être déplacé le long de la première cellule depuis la zone située à l'extérieur du dispositif d'aimants (1, 2) jusqu'à la paroi de séparation (15) et éventuellement encore au-delà de cette paroi.

4. Spectromètre suivant l'une des revendications précédentes, caractérisé par le fait qu'un certain nombre de grilles de potentiel (27) parallèles à la paroi de séparation (15) sont disposées dans la seconde cellule (11) et sont reliées d'une manière électriquement conductrice à l'appareil d'alimentation réseau (26) et limitent le puits pour les ions à une section, voisine de la paroi de séparation (15), de la seconde cellule (11).

5. Spectromètre suivant la revendication 4, caractérisé par le fait qu'une électrode de protection (19) est disposée entre la paroi de séparation (15) et la grille de potentiel (27) qui délimite le puits pour les ions de la seconde cellule (11) et est voisine de la paroi de séparation (15).

6. Spectromètre suivant l'une des revendications 3 à 5, caractérisé par le fait qu'à l'intérieur de la cellule (8) se trouvent disposées, au moins entre deux grilles de potentiel (24) voisines, des électrodes (30) parallèles au champ magnétique et servant à produire des champs alternatifs convenant pour l'excitation de résonances cyclotroniques ioniques.